# EUROPÄISCHE PATENTSCHRIFT

(11) **EP 3 358 359 B1**
(45) Veröffentlichungstag und Bekanntmachung des Hinweises auf die Patenterteilung: **28.08.2019**
(21) Anmeldenummer: 17154199.8
(22) Anmeldetag: 01.02.2017
(51) Int. Cl.: G01R 15/24, H05K 1/02

(54) **LEITERPLATTE MIT IMPLANTIERTEM OPTISCHEN STROMSENSOR**
PRINTED CIRCUIT BOARD WITH IMPLANTED OPTICAL CURRENT SENSOR
CIRCUIT IMPRIMÉ COMPRENANT UN CAPTEUR DE COURANT OPTIQUE IMPLANTÉ

(43) Veröffentlichungstag der Anmeldung: 08.08.2018
(73) Patentinhaber: Siemens Aktiengesellschaft, 80333 München (DE)
(72) Erfinder: Pfefferlein, Stefan, 90562 Heroldsberg (DE); Wetzel, Ulrich, 91058 Erlangen (DE)

(56) Entgegenhaltungen:
- JP-A- 2013 152 225
- US-B1- 7 295 725

## Beschreibung

Die Erfindung betrifft eine Leiterplatte mit einer Leiterbahn aufweisend eine Aussparung, welche derart im Verlauf der Leiterbahn angeordnet ist, dass die Leiterbahn unterbrochen ist, wobei in der Aussparung ein Implantat mit einen linken, rechten, unteren und oberen Rand angeordnet ist. Das Implantat dient der Messung des in der Leiterbahn verlaufenden Stromes.

Bei der Messung von Strom und Spannung bei Baugruppen für die Leistungselektronik, beispielsweise Umrichtern, ergeben sich durch starke elektromagnetische Felder und zeitliche Änderungen der hohen Ströme bei Wechselstrombetrieb oftmals elektromagnetische Verträglichkeitsprobleme. Abhängig von einem bisher bekannten Messverfahren, beispielsweise einem Shunt, oder einem XMR-Verfahren, ist der Aufwand für eine Strommessung nicht unerheblich, um eine ausreichende Messgenauigkeit zu erzielen. Z.B. beeinflusst eine magnetische Zentrierung der Flussdichte in weichmagnetischen Kernen eine Strommessung in zweierlei Hinsicht. Einerseits wird damit eine zusätzliche Induktivität in dem zu messenden Stromkreis eingeführt, so dass die ursprünglichen Stromverläufe verändert werden. Andererseits können bei hochfrequenten Strömen so große Verluste im Kern entstehen, dass eine Messung nur kurz oder gar nicht möglich ist.

Darüber hinaus ist bei der Strommessung mit Shuntwiderständen auch mit einer größeren Verlustleistung zu rechnen, die ggf. auch über entsprechenden Kühlaufwand abgeführt werden muss und somit den Systemwirkungsgrad verschlechtert.

Weiterhin ist es ein Problem bei der elektromagnetischen Messung mit Eisenkernen oder -spulen, dass meist ein vorhandener Bauraum auf der Leiterplatte nur begrenzt ist.

Es ist Aufgabe der vorliegenden Erfindung Mittel für eine Strommessung bereitzustellen, welche besonders störfest gegen elektromagnetische Einflüsse sind, nur einen minimalen Bauraum in einem Gerät bzw. auf einer Leiterplatte beanspruchen und den Systemwirkungsgrad nicht nennenswert beeinflussen.

Aus der Offenlegungsschrift DE 100 00 306 A1 ist ein faseroptischer Stromsensor bekannt. Dieser faseroptische Stromsensor arbeitet mit dem magnetooptischen oder Faraday-Effekt. Aufgrund des Magnetfeldes wird ein durch einen Lichtleiter gesendetes Licht phasenverschoben. Die Phasenverschiebung ist dabei proportional zum Strom und kann gemessen werden.

Die bisher bekannten faseroptischen Stromsensoren, wie beispielsweise ein faseroptischer Stromsensor von ABB (www.abb.de/cawp/seitp202/c8448d801f0635dbc1257169002d8156.as px) sind in ihren Bauformen und Abmessungen für den Einsatz auf einer Leiterplatte viel zu groß. Auch von der Firma Phoenix Contact gibt es einen faseroptischen Stromsensor in ringform, welcher auf eine Hutschiene aufgeklemmt wird, und durch den man ein Kabel führen muss. Auch dieser kommt für den Einsatz auf einer Leiterplatte nicht in Frage.

Die eingangs genannte Aufgabe wird dadurch gelöst, dass erfindungsgemäß ein Implantat für die Leiterplatte bereitgestellt wird, welches in der Leiterplatte angeordnet wird. Dabei weist das Implantat einen Leiter auf, welcher bei eingesetztem Implantat in die Leiterplatte die durch die Aussparung aufgetrennte Leiterbahn schließt, wobei das Implantat eine erste optische Schicht und eine zweite optische Schicht aufweist, und der Leiter zwischen den beiden Schichten angeordnet ist, die erste und die zweite optische Schicht, weisen jeweils zumindest eine Lichtleitstruktur mit einem ersten Ende und einem zweiten Ende auf, wobei in einem rechten Randbereich des Implantats, in welchem die jeweils zweiten Enden der Lichtleitstrukturen liegen, ein Lichtleitmittel angeordnet ist, damit ein an dem ersten Ende der Lichtleitstruktur der ersten optischen Schicht eingespeistes Licht zum zweiten Ende der Lichtleitstruktur der zweiten optischen Schicht umgelenkt wird, damit ein Strahlengang des Lichtes den Leiter umschließt, weiterhin weist das Implantat oder die Leiterplatte einen optischen Sender und einen optischen Empfänger mit Auswertemitteln auf, wodurch ein faseroptischer Stromsensor zur Strommessung eines durch den Leiter fließenden Stromes gebildet ist. Die Auswertemittel sind dabei dazu ausgestaltet, die Phasenverschiebung zwischen dem gesendeten und dem empfangenen Licht zu ermitteln.

Mit dem Implantat hat man nun eine berührungslose Strommessvorrichtung, welche innerhalb einer Leiterbahn eingebettet ist. Erfindungsgemäß wird für das Implantat die Technologie der dreidimensionalen elektrisch-optischen Leiterplatten (EOCB = Electro Optical Circuit Board) genutzt. Für die Integration von optischen Übertragungsstrecken in das Implantat bzw. in die für das Implantat genutzte EOCB-Leiterplatte, werden beispielsweise vollflächig integrierte Glasfolien eingearbeitet. Diese Glasfolien sind geeignet, um darin Lichtleitstrukturen einzuarbeiten. Mit diesen in die Leiterplatte bzw. das Implantat integrierten Lichtleitstrukturen hat man einen faseroptischen Sensor als einen Leitplattenaufbau realisiert. Die Lichtleitstrukturen lassen sich vorteilhafterweise nach der Methode der Brechungsindexmodifikation mittels Laser in transparenten Materialien realisieren.

Mit der Erfindung kann man nun in einfacher Weise die für das faseroptische Strommessprinzip notwendigen Leiter umschließenden Fasern als ein EOCB mit eingearbeiteten Lichtleitstrukturen nachbilden und für die berührungslose und rückwirkungsfreie Strommessung nutzen. Dabei kann man Abschnitte einer bereits bestehenden Leiterplatte zur Strommessung nutzen, in dem man ein EOCB-Implantat in eine herkömmliche Leiterplatte integriert.

Es wird also mit Vorteil aus einem ohnehin vorhandenen Stück Leiterbahn ein Stück entfernt und durch ein Stück Leiter aufgebaut als ein EOCB mit Lichtleitstrukturen ersetzt. Dieses als Implantat ausgestaltete EOCB ist zusätzlich als ein optischer Stromsensor aufgebaut, welcher nach dem Faraday Effekt zur Messung von elektrischem Strom arbeitet.

In einer weiteren Ausgestaltung ist zusätzlich in dem linken Randbereich des Implantates bzw. der Leiterplatte ein weiteres Lichtleitmittel angeordnet und die erste und die zweite optische Schicht weisen eine Vielzahl von Lichtleitstrukturen auf, wobei die jeweiligen Enden der Lichtleitstruktur über die Lichtleitmittel gekoppelt sind und damit der Strahlengang des Lichtes den Leiter wie eine Wicklung umschließt.

In einer weiteren Ausgestaltungsalternative sind die ersten Enden und die zweiten Enden jeweils bündig mit dem linken Randbereich bzw. dem rechten Randbereich abschließend angeordnet und die Lichtleitmittel sind vom Profil her trapezförmig ausgestaltet, dabei ist die längere Grundseite des Trapezes zu den Enden hin angeordnet und damit kann an den Schenkeln im Inneren des Trapezes der Lichtleitmittel eine Totalreflexion für den Strahlengang erfolgen.

Eine andere Alternative sieht vor, dass die ersten Enden und die zweiten Enden für eine Totalreflexion abgeschrägt sind und jeweils über den linken Randbereich bzw. den rechten Randbereich hinaus angeordnet sind und die Lichtleitmittel vom Profil her rechteckig ausgestaltet sind und zwischen den ersten Enden und den zweiten Enden angeordnet sind.

Um beispielsweise das Implantat in die Leiterplatte elektrisch sicher anzubinden, weist eine Außenkontur des unteren und oberen Randes des Implantates und/oder eine Innenkontur des Randes der zugeordneten Aussparung eine periodisch sich wiederholende Struktur, insbesondere eine gezahnte, gezackte oder gewellte Struktur auf, die Struktur ist dabei vorzugsweise metallisch beschichtet und kann in einem Reflow-Prozess an die Leiterplatte elektrisch kontaktiert werden.

In Bezug auf die eingangs genannte Problematik der Strommessung bei der Leistungselektronik wird die eingangs genannte Aufgabe ebenso durch einen Umrichter mit einer Leiterplatte nach einem der Ansprüche 1 bis 5 gelöst.

Die Zeichnung zeigt ein Ausführungsbeispiel der Erfindung. Es zeigt
- FIG 1: eine Leiterplatte mit einer Aussparung,
- FIG 2: die Leiterplatte mit in die Aussparung eingesetzten Implantat,
- FIG 3: eine Schnittdarstellung des Implantates mit Sicht auf die optischen Schichten,
- FIG 4: ebenfalls eine Schnittdarstellung des Implantates um die Umlenkung des Strahlenganges aufzuzeichnen und
- FIG 5: einen Umrichter mit in die Leiterplatte integrierten Strommessvorrichtungen.

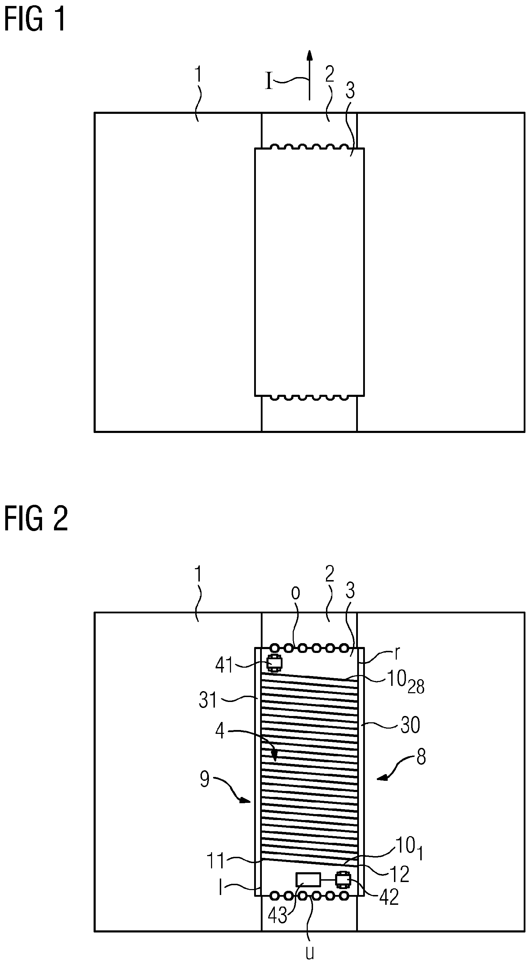

Gemäß FIG 1 ist eine Leiterplatte 1 mit einer Leiterbahn 2 gezeigt. Die Leiterbahn 2 dient dem Führen eines Stromes I. Um eine Strommessvorrichtung in die Leiterplatte 1 zu integrieren, weist die Leiterplatte eine Aussparung 3 auf, welche derart im Verlauf der Leiterbahn 2 angeordnet ist, dass die Leiterbahn 2 unterbrochen ist, wobei später bei in der Aussparung 3 eingestecktem Implantat 4 eine Strommessung mit dem Implantat 4 möglich ist.

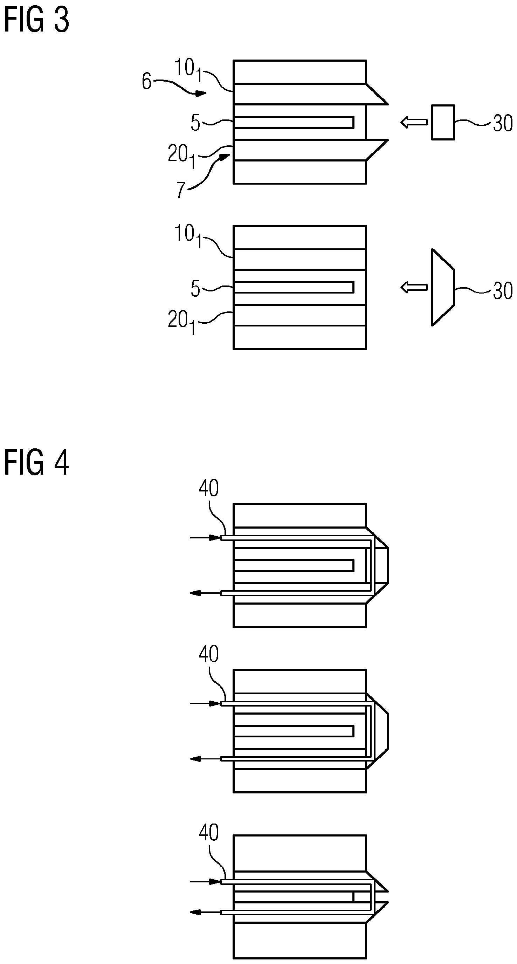

FIG 2 zeigt die aus FIG 1 bekannte Leiterplatte 1 mit in die Aussparung 3 angeordneten Implantat 4. Das Implantat 4 hat einen linken l, einen rechten r, unteren u und oberen Rand o. Dabei ist das Implantat 4 mit einem Leiter 5 (siehe FIG 3) versehen, welcher bei eingesetztem Implantat 4 die durch die Aussparung 3 aufgetrennte Leiterbahn 2 für einen Stromfluss schließt. Das Implantat 4 weist eine erste optische Schicht 6 und eine zweite optische Schicht 7 auf, und der Leiter 5 ist zwischen den beiden Schichten 6,7 angeordnet. Die erste und die zweite optische Schicht 6,7 weisen jeweils mehrere Lichtleitstrukturen 10₁,..., 10₂₈ auf.

Gemäß der FIG 2 kann nur von der oberen Seite auf das Implantat 4 geblickt werden. Die untere Seite des Implantates 4 weist ebenfalls mehrere Lichtleitstrukturen 20₁,..., 20₂₈ auf. Die Lichtleitstrukturen 10₁,...,10₂₈ und 20₁,...,20₂₈ sind als eine Lichtleitkanäle in einem Dünnglas einer EOCB-Leiterplatte angeordnet, wobei das Dünnglas die optischen Schichten 6,7 darstellt.

In einem rechten Randbereich 8 des Implantates 4, in welchem die jeweils zweiten Enden 12 der Lichtleitstrukturen liegen, ist ein Lichtleitmittel 30 angeordnet, damit ein an dem ersten Ende 11 einer Lichtleitstruktur 10₁ der ersten optischen Schicht 6 eingespeistes Licht zum zweiten Ende 12 der Lichtleitstruktur 20₁ der zweiten optischen Schicht 7 umgelenkt wird, damit ein Strahlengang 40 des Lichtes den Leiter 5 umschließt. Zusätzlich ist in einem linken Randbereich 9 ein weiteres Lichtleitmittel 31 angeordnet, um die Vielzahl der Lichtleitstrukturen der ersten und zweiten optischen Schicht miteinander zu koppeln. Mit Hilfe der Lichtleitmittel 30,31 wird also die Vielzahl der Lichtleitstrukturen derart optisch gekoppelt, dass der Strahlengang des Lichtes den Leiter 5 wie eine Wicklung mehrfach umschließt.

Auf dem Implantat 4 ist ein optischer Sender 41 und ein optischer Empfänger 42 mit Auswertemitteln 43 angeordnet, wodurch ein faseroptischer Stromsensor zur Strommessung eines durch den Leiter 5 fließenden Stromes gebildet wird.

Gemäß der FIG 3 werden mögliche Anordnungen für ein Umlenken des Strahlenganges mittels der Lichtleitmittel 30,31 aufgezeigt. Bei der oberen Variante sind die ersten Enden und die zweiten Enden für eine Totalreflexion abgeschrägt und sind jeweils über den linken bzw. rechten Randbereich 8 hinaus angeordnet und die Lichtleitmittel 30,31 sind vom Profil her rechteckig ausgestaltet und zwischen den ersten Enden 11 und den zweiten Enden 12 angeordnet.

Bei der unteren Ausgestaltungsvariante sind die ersten Enden 11 und die zweiten Enden 12 jeweils bündig mit dem linken Randbereich 8 bzw. dem rechten Randbereich (wobei in FIG 3 jeweils immer nur der rechte Randbereich 8 gezeigt ist) abschließend angeordnet und die Lichtleitmittel 30,31 sind vom Profil her trapezförmig ausgestaltet, wobei die längere Grundseite des Trapezes zu den Enden hin angeordnet ist, damit an den Schenkeln des Trapezes im Inneren der Lichtleitmittel 30,31 eine Totalreflexion für den Strahlengang erfolgen kann.

Mit der FIG 4 wird das Prinzip des Umlenkens des Strahlenganges innerhalb der Leiterplatte noch einmal aufgezeigt. Ausgehend von einer EOCB-Leiterplatte, also eine Leiterplatte mit integrierten Dünnglasschichtlichtleitstrukturen, kann durch Ansetzen eines Trapezes an die erste Schicht 6 und die zweite Schicht 7 ein in die Lichtleitstruktur eingespeister Strahl des Lichtes von der ersten Schicht 6 in die zweite Schicht 7 umgelenkt werden. Die obere Ausgestaltungsvariante zeigt dabei eine Umlenkung durch ein rechteckiges Profil und die mittlere Ausgestaltungsvariante zeigt dabei eine Umlenkung durch ein trapezförmiges Profil, wobei die untere Ausgestaltungsvariante ganz ohne ein Umlenkmittel auskommt, weil hier die erste optische Schicht 6 und die zweite optische Schicht 7 derart nahe zueinander angeordnet sind, dass bei abgeschrägten Enden der Lichtleitstrukturen das Licht so wieder aus- und eingekoppelt wird.

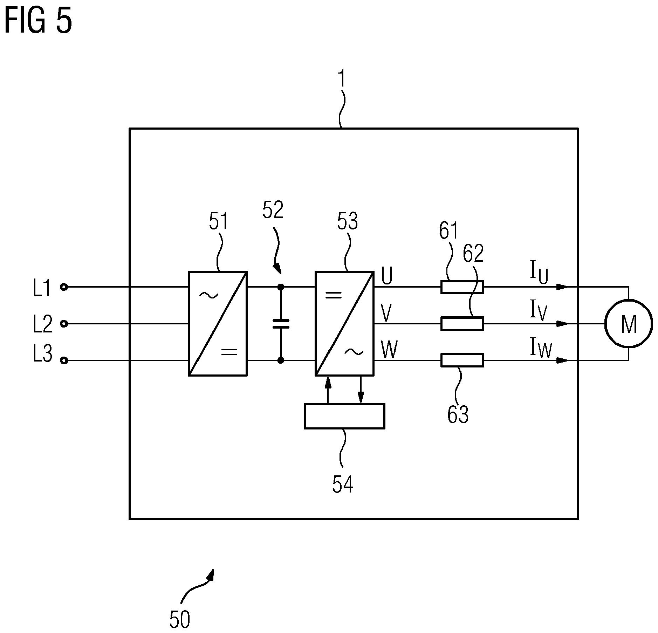

Das erfindungsgemäße Implantat ausgestaltet als ein faseroptischer Sensor, kann mit Vorteil, gemäß FIG 5 in einem Umrichter 50 eingesetzt werden. Der Umrichter 50 ist ein Dreiphasen-Umrichter L1,L2,L3 und kann einen Motor M über drei Leitungen U,V,W ansteuern. Der Umrichter 50 weist einen Gleichrichter/Netzfilter 51, einen Zwischenkreis 52, einen Wechselrichter 53 und eine Regelelektronik 54 auf. Erfindungsgemäß ist zwischen dem Wechselrichter 53 und dem anzusteuernden Motor M in die Leiterplatte 1 pro Leitung U,V,W jeweils eine erste Strommesseinrichtung 61, eine zweite Strommesseinrichtung 62 und eine dritte Strommesseinrichtung 63 in die Leiterplatte 1 integriert. Die Strommesseinrichtung 61,62,63 sind dabei jeweils als das zuvor beschriebene Implantat 4 ausgestaltet.

## Patentansprüche

1. Leiterplatte (1) mit einer Leiterbahn (2) aufweisend eine Aussparung (3), welche derart im Verlauf der Leiterbahn (2) angeordnet ist, dass die Leiterbahn (2) unterbrochen ist, wobei in der Aussparung (3) ein Implantat (4) mit einem linken, rechten, unteren und oberen Rand (l,r,u,o) angeordnet ist,
**dadurch gekennzeichnet, dass**
- in dem Implantat (4) ein Leiter (5) angeordnet ist, welcher bei eingesetztem Implantat (4) die durch die Aussparung (3) aufgetrennte Leiterbahn (2) schließt,
- wobei das Implantat (4) eine erste optische Schicht (6) und eine zweite optische Schicht (7) aufweist und der Leiter (5) zwischen den beiden Schichten (6,7) angeordnet ist, die erste und die zweite optische Schicht (6,7) weisen jeweils zumindest eine Lichtleitstruktur (10₁,20₁) mit einem ersten Ende (11) und einem zweiten Ende (12) auf,
- wobei in einem rechten Randbereich (8) des Implantats (4), in welchen die jeweils zweiten Enden (12) der Lichtleitfasern (10₁,20₁) liegen, ein Lichtleitmittel (30) angeordnet ist, damit ein an dem ersten Ende (11) der Lichtleitstruktur (10₁) der ersten optischen Schicht (6) eingespeistes Licht zum zweiten Ende (12) der Lichtleitstruktur (20₁) der zweiten optische Schicht (7) umgelenkt wird, damit ein Strahlengang (40) des Lichtes den Leiter (5) umschließt,
- weiterhin aufweisend einen optischen Sender (41) und einen optischen Empfänger (42) mit Auswertemitteln (43), wodurch ein faseroptischer Stromsensor zur Strommessung eines durch den Leiter (5) fließenden Stromes (I) gebildet wird.

2. Leiterplatte (1) nach Anspruch 1, wobei zusätzlich in dem linken Randbereich (9) ein weiteres Lichtleitmittel (31) angeordnet ist, und die erste und die zweite optische Schicht (6,7) eine Vielzahl von Lichtleitstrukturen (10₁,20₁) aufweisen, wobei die jeweiligen Enden (11,12) der Lichtleitstrukturen (10₁,20₁) über die Lichtleitmittel (30,31) gekoppelt sind, damit der Strahlengang (40) des Lichtes den Leiter (5) wie eine Wicklung umschließt.

3. Leiterplatte (1) nach Anspruch 2, wobei die ersten Enden (11) und die zweiten Enden (12) jeweils bündig mit dem linken Randbereich (9) bzw. rechten Randbereich (8) abschließen und die Lichtleitmittel (30,31) vom Profil her trapezförmig ausgestaltet sind und die längere Grundseite des Trapezes zu den Enden (11,12) hin angeordnet ist, damit an den Schenkeln im Inneren der Lichtleitmittel (30,31) eine total Reflexion für den Strahlengang (40) erfolgen kann.

4. Leiterplatte (1) nach Anspruch 2, wobei die ersten Enden (11) und die zweiten Enden (12) für eine total Reflexion abgeschrägt sind und jeweils über den linken Randbereich (9) bzw. rechten Randbereich (8) hinaus angeordnet sind und die Lichtleitmittel (30,31) vom Profil her rechteckig ausgestaltet sind und zwischen den ersten Enden (11) und den zweiten Enden (12) angeordnet sind.

5. Leiterplatte (1) nach einem der Ansprüche 1 bis 4, wobei eine Außenkontur des unteren und oberen Randes (u,o) des Implantats (4) und/oder die Innenkontur des Randes der zugeordneten Aussparung (B) eine periodisch sich wiederholende Struktur, insbesondere eine gezahnte, gezackte oder gewellte Struktur, aufweist bzw. aufweisen.

6. Umrichter (50) mit einer Leiterplatte (1) nach einem der Ansprüche 1 bis 5.

## Claims

1. Circuit board (1) with a conductor path (2) having a recess (3) which is arranged in the course of the conductor path (2) such that the conductor path (2) is interrupted, wherein an implant (4) with a left, right, lower and upper edge (l,r,u,o) is arranged in the recess (3),
**characterised in that**
- a conductor (5) is arranged in the implant (4) which, with the implant (4) inserted, closes the conductor path (2) separated by the recess (3),
- wherein the implant (4) has a first optical layer (6) and a second optical layer (7) and the conductor (5) is arranged between the two layers (6,7), the first and the second optical layer (6,7) each having at least one light-conducting structure (10₁,20₁) with a first end (11) and a second end (12),
- wherein in a right edge region (8) of the implant (4) in which the respective second ends (12) of the optical fibres (10₁,20₁) are located, a light-conducting means (30) is arranged so that light fed in at the first end (11) of the light-conducting structure (10₁) of the first optical layer (6) is deflected to the second end (12) of the light-conducting structure (20₁) of the second optical layer (7) so that a beam path (40) of the light encompasses the conductor (5),
- furthermore, having an optical transmitter (41) and an optical receiver (42) with evaluation means (43), whereby a fibre optic current sensor for current measurement of a current (I) flowing through the conductor (5) is formed.

2. Circuit board (1) according to claim 1, wherein a further light-conducting means (31) is additionally arranged in the left edge region (9), and the first and the second optical layer (6,7) have a plurality of light-conducting structures (10₁,20₁), wherein the respective ends (11,12) of the light-conducting structures (10₁,20₁) are coupled by way of the light-conducting means (30,31) so that the beam path (40) of the light encompasses the conductor (5) like a winding.

3. Circuit board (1) according to claim 2, wherein the first ends (11) and the second ends (12) are each flush with the left edge region (9) and/or right edge region (8) and the light-conducting means (30,31) are trapezoidal in profile and the longer base side of the trapezoid is arranged towards the ends (11,12) so that a total reflection can take place for the beam path (40) on the arms inside the light-conducting means (30,31).

4. Circuit board (1) according to claim 2, wherein the first ends (11) and the second ends (12) are bevelled for a total reflection and are each arranged beyond the left edge region (9) and/or right edge region (8) and the light-conducting means (30,31) are rectangular in profile and are arranged between the first ends (11) and the second ends (12).

5. Circuit board (1) according to one of the claims 1 to 4, wherein an outer contour of the lower and upper edge (u,o) of the implant (4) and/or the inner contour of the edge of the assigned recess (B) has and/or have a periodically recurring structure, in particular a serrated, jagged or undulating structure.

6. Inverter (50) with a circuit board (1) according to one of the claims 1 to 5.

## Revendications

1. Plaquette (1) à circuit imprimé, comprenant une piste (2) conductrice, ayant un évidement (3) disposé dans le tracé de la piste (2) conductrice, de manière à ce que la piste (2) conductrice soit interrompue, un implant (4) ayant un bord (l,r,u,o) gauche, droit, inférieur et supérieur étant disposé dans l'évidement (3),
**caractérisée en ce que**
- dans l'implant (4) est disposé un conducteur (5), qui, lorsque l'implant (4) est inséré, ferme la piste (2) conductrice séparée par l'évidement (3),
- dans laquelle l'implant (4) a une première couche (6) optique et une deuxième couche (7) optique et le conducteur est disposé entre les deux couches (6, 7), la première et la deuxième couches (6, 7) optiques ayant chacune au moins une structure (10₁, 20₁) de fibre optique ayant un premier bout (11) et un deuxième bout (12),
- dans laquelle, dans une partie (8) de bord droit de l'implant (4), dans laquelle se trouvent les deuxièmes bouts (12) respectifs des fibres (10₁, 20₁) optiques, est disposé un moyen (30) de guidage de la lumière, afin que de la lumière injectée au premier bout (11) de la structure (10₁) de fibre optique de la première couche (6) optique soit déviée vers le deuxième bout (12) de la structure (20₁) de fibre optique de la deuxième couche (7) optique, afin qu'un trajet (40) des rayons de la lumière entoure le conducteur (5),
- comportant, en outre, un émetteur (41) optique et un récepteur (42) optique ayant des moyens (43) d'exploitation, grâce à quoi un capteur de courant à fibre optique est formé pour mesurer un courant (I) passant dans le conducteur (5).

2. Plaquette (1) à circuit imprimé suivant la revendication 1, dans laquelle, supplémentairement, dans la partie (9) de bord gauche est disposé un autre moyen (31) à fibre optique et la première et la deuxième couches (6, 7) optiques ont une pluralité de structures (10₁, 20₁) de fibre optiques, les bouts (11, 12) respectifs des structures (10₁, 20₁) de fibre optique étant couplés par les moyens (30, 31) à fibre optique, afin que le trajet (40) des rayons de la lumière entoure le conducteur (5) comme un enroulement.

3. Plaquette (1) à circuit imprimé suivant la revendication 2, dans laquelle les premiers bouts (11) et les deuxième bout (12) sont à affleurement, respectivement, avec la partie (9) de bord gauche et la partie (8) de bord droit et les moyens (30, 31) de fibre optique sont conformés de profil en forme de trapèze et le côté de base le plus long du trapèze est disposé vers les bouts (11, 12), afin de pouvoir effectuer, sur les branches à l'intérieur des moyens (30, 31) à fibre optique, une réflexion totale du trajet (40) des rayons.

4. Plaquette (1) à circuit imprimé suivant la revendication 2, dans laquelle les premiers bouts (11) et les deuxième bouts (12) sont biseautés pour une réflexion totale et sont disposés chacun au-delà de la partie (9) de bord gauche et de la partie (8) de bord droit et des moyens (30, 31) à fibre optique sont conformés de profil de façon rectangulaire et sont disposés entre les premiers bouts (11) et les deuxième bouts (12).

5. Plaquette (1) à circuit imprimé suivant l'une des revendications 1 à 4, dans laquelle un contour extérieur du bord (u,o) inférieur et supérieur de l'implant (4) et/ou le contour intérieur du bord de l'évidement (B) associé ont une structure récurrente périodiquement, notamment une structure dentée, en zigzag ou ondulée.

6. Onduleur (50) ayant une plaquette (1) à circuit imprimé suivant l'une des revendications 1 à 5.
